(19) Europäisches Patentamt
European Patent Office
Office européen des brevets

(11) Veröffentlichungsnummer: **0 200 129 B1**

(12) **EUROPÄISCHE PATENTSCHRIFT**

(45) Veröffentlichungstag der Patentschrift: **05.02.92**

(51) Int. Cl.[5]: **G03F 7/022**, G03F 7/09

(21) Anmeldenummer: **86105450.0**

(22) Anmeldetag: **19.04.86**

# (54) Positiv-Fotoresist-Zusammensetzungen.

(30) Priorität: **02.05.85 DE 3515693**

(43) Veröffentlichungstag der Anmeldung:
**05.11.86 Patentblatt 86/45**

(45) Bekanntmachung des Hinweises auf die Patenterteilung:
**05.02.92 Patentblatt 92/06**

(84) Benannte Vertragsstaaten:
**AT DE FR GB IT NL**

(56) Entgegenhaltungen:
**EP-A- 0 159 428**
**GB-A- 2 085 609**
**US-A- 4 362 809**

**PATENT ABSTRACTS OF JAPAN, Band 9, Nr. 86 (P-349)[1809], 16. April 1985; & JP-A-59 214 847 (NAGASE KASEI KOGYO K.K.)**

**IEEE TRANSACTIONS ON ELECTRON DEVICES, Band ED-28, Nr. 11, November 1981, Seiten 1405-1410, IEEE, New York, US; M.M. O'TOOLE et al.: "Linewidth control in projection lithography using a multilayer resist process"**

(73) Patentinhaber: **CIBA-GEIGY AG**
**Klybeckstrasse 141**
**CH-4002 Basel(CH)**

(72) Erfinder: **Merrem, Hans Joachim, Dr.**
**Donnersbergstrasse 6**
**W-6104 Seeheim(DE)**

EP 0 200 129 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Positiv-Fotoresist-Zusammensetzungen, die einen Zusatz von strahlungsabsorbierenden Verbindungen zur Unterdrückung von Streustrahlungs- bzw. Halationseffekten enthalten.

Fotoresists dienen in vielfältiger Weise als hochwertige Prozeßchemikalien bei der Herstellung von elektrischen Schaltungen und elektronischen Bauteilen und werden insbesondere bei der Strukturierung von Leiter- bzw. Halbleitersubstraten durch fotolithographische Techniken eingesetzt.

Gemäß den üblicherweise angewandten Prozeßabläufen werden die Substrate mit der Fotoresist-Zusammensetzung beschichtet, die Fotoresistschicht anschließend durch eine Bildvorlage mit energiereicher Strahlung, im allgemeinen Ultraviolettstrahlung, belichtet und danach entwickelt.

Im Falle von Positiv-Fotoresists wird in den entsprechend dem Bildmuster der Vorlage der Strahlung ausgesetzten Bereichen der Schicht durch die Strahlungseinwirkung die Löslichkeit in einem Entwickler erhöht. Im Entwicklungsschritt werden die belichteten Teile der Schicht entfernt, wobei die unbelichteten und somit unlöslichen Teile als eine ein positives Bild der Vorlage wiedergebende Reliefstruktur auf der Substratoberfläche verbleiben.

Im Falle von Negativ-Fotoresists erfolgt durch die Strahlungseinwirkung in der Schicht eine Vernetzung, die die Löslichkeit in einem entsprechenden Entwickler vermindert. Im Entwicklungsschritt werden die unbestrahlten Bereiche der Schicht entfernt und es verbleibt ein negatives Bild der Vorlage als Reliefstruktur auf dem Substrat.

Die ständig fortschreitende Miniaturisierung in der Halbleitertechnologie und Mikroelektronik stellt an die mit Hilfe von Fotoresistmaterialien darzustellenden Bildstrukturen immer höhere Anforderungen, insbesondere hinsichtlich Auflösung und Kantensteilheit der Fotoresist-Reliefstrukturen, aber auch an die Haftfestigkeit, mechanische und chemische Stabilität, Dimensionstreue und Beständigkeit bei erhöhten Temperaturen oder anderen Einflüssen, die bei den weiteren Prozeßschritten einwirken können.

Positiv-Fotoresists sind heute bei der Erzeugung von Fein- und Feinststrukturen immer noch bevorzugt, da sie insbesondere hinsichtlich des Auflösungsvermögens die günstigeren Eigenschaften aufweisen.

Die heute üblichen Positiv-Fotoresist-Zusammensetzungen enthalten, gelöst in einem organischen Lösungsmittel, im wesentlichen Phenol-Formaldehyd-Kondensate vom Novolakharz-Typ und Verbindungen vom Typ der o-Diazochinone als lichtempfindliche Komponenten. Derartige Zusammensetzungen sind in wäßrig-alkalischen Entwicklungsbädern entwickelbar.

Positiv-Fotoresists nach dem Stand der Technik sind jedoch noch verbesserungswürdig. Es ist generell in der Fotoresist-Technologie ein bekanntes Problem, daß bei der Anwendung auf Substraten, die eine Oberfläche mit hohem Reflexionsvermögen aufweisen - dies ist in der Regel bei Halbleitermaterialien und Metallen wie beispielsweise Silizium, Aluminium, Kupfer, Chrom usw. der Fall -, das Auflösungsvermögen des Fotoresists bei der Bestrahlung durch an der Oberfläche des Substrats auftretende Reflexionserscheinungen erheblich vermindert wird. Durch unregelmäßige Streuung des eingestrahlten Lichts an der Substratoberfläche dringt Streulicht in Bereiche der Resistschicht, die entsprechend dem Bildmuster der Vorlage keiner Strahlung ausgesetzt sein sollten. Durch derartige Streu- und Halationseffekte werden nach der Entwicklung Reliefstrukturen mit verminderter Kantenschärfe und -Steilheit erhalten. Feine und feinste Strukturen, wie sie in der Mikroelektronik erzeugt werden sollen, sind durch diese Effekte nur noch mit eingeschränkter Wiedergabetreue erhältlich.

Zur Bewältigung derartiger Probleme ist es insbesondere aus der Negativ-Fotoresist-Technik bekannt, den Resistzusammensetzungen strahlungsabsorbierende Farbstoffe zur Reduzierung unerwünschter Belichtungseffekte Zuzusetzen. Die an solche Farbstoffe gestellten Anforderungen sind z.B. hohes Absorptionsvermögen im Wellenlängenbereich der Belichtungsapparatur, Kompatibilität mit der Fotoresist-Zusammensetzung, d.h. insbesondere eine ausreichende Löslichkeit hierin, und Beständigkeit unter den Bedingungen der Prozeßabläufe.

Unter den bislang hierfür eingesetzten Farbstoffen zeigen Aminoazobenzol-Derivate, wie sie als Zusätze zu Negativ-Fotoresists auf Basis von zyklisiertem Kautschuk und Bisazido-Strahlungsvernetzern beispielsweise in der JP 51 (76) 37 562 oder dem US Patent 4,268,603 vorgeschlagen werden, die günstigsten Absorptionseigenschaften. Diese Substanzen haben allerdings den Nachteil, daß sie nur relativ wenig in Fotoresists löslich sind und darüberhinaus bei erhöhten Temperaturen bis etwa 100 °c - solche Temperaturen werden üblicherweise nach der Beschichtung in dem Prozeßschritt des Vortrocknens ("prebake") angewandt - in erheblichem Maß aus der Resistschicht heraus sublimieren. Günstiger in dieser Hinsicht sind die Aminoazobenzol-Derivate der DE-OS 33 24 795, die noch bei Temperaturen um 120 °C stabil sind.

Es zeigte sich jedoch, daß trotz ihrer günstigen Absorptionseigenschaften die Anwendung der aus der Negativ-Fotoresist-Technik bekannten Farbstoffe in Positiv-Fotoresists nicht zum gewünschten Erfolg führt.

In den Prozeßabläufen zur Strukturierung von Halbleitersubstraten mit Hilfe von Positiv-Fotoresists treten vielfach Temperaturen von 150° bis etwa 200°C auf, so etwa bei den üblichen Temperschritten ("prebake", "postbake"), die zur Erhöhung der Haftfestigkeit der Resistschicht auf dem Substrat und der Erhöhung der Stabilität erforderlich sind. Darüberhinaus treten solche Temperaturbelastungen während Plasmaätz- und Ionenimplantationsverfahren auf. Auch die temperaturstabilsten bekannten Farbstoffe sublimieren bei diesen Temperaturen aus der Resistschicht, wodurch diese die gewünschten Absorptionseigenschaften verliert, was sich dann drastisch auf Auflösungsvermögen und Kantensteilheit des zu erzeugenden Resistbildes auswirkt.

Gleichzeitig verursacht der sublimierte Farbstoff äußerst unerwünschte Verunreinigungen in den Prozeßgeräten.

Es bestand daher die Aufgabe, Farbstoffe mit günstigen Absorptionseigenschaften aufzufinden, die mit Positiv-Fotoresists kompatibel sind und darüberhinaus auch bei Temperaturen bis um 200 °C sich nicht aus der Resistschicht verflüchtigen.

Es wurde nun gefunden, daß diese Anforderung in hervorragender Weise von Verbindungen der allgemeinen Formel I

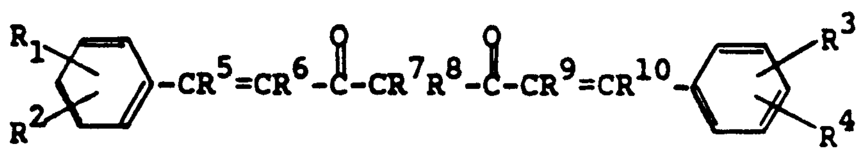

(I)

worin $R_1$ bis $R_4$ jeweils Hydroxy oder $C_{1-6}$-Alkoxy und $R^5$ bis $R^{10}$ jeweils Wasserstoff oder $C_{1-6}$-Alkyl bedeutet, erfüllt werden.

Gegenstand der Erfindung sind somit Positiv-Fotoresist-Zusammensetzungen auf Diazochinon/Novolakharz-Basis, die mindestens eine Verbindung der allgemeinen Formel I enthalten.

Gegenstand der Erfindung ist darüberhinaus die Verwendung von Verbindungen der allgemeinen Formel I zur Unterdrückung von Streustrahlungs- und Halationseffekten in Positiv-Fotoresist-Beschichtungen. Die Verwendung des unter die allgemeine Formel I fallenden Farbstoffs curcumin zur vermeidung von Halationseffekten ist aus der GB-A-2085609 bekannt.

Die Verbindungen der Formel I sind terminal aromatisch substituierte Heptadiendione, in denen die aromatischen Substituenten Hydroxy- bzw. Alkoxyreste tragen.

Die Reste $R^1$, $R^2$, $R^3$, $R^4$ können unabhängig voneinander Hydroxy oder Alkoxy mit 1 bis 6 C-Atomen bedeuten und beliebig die freien Ringpositionen der Phenylringe besetzen. Vorzugsweise besetzt jeweils immer einer der Reste die Para-, der zweite die Meta-Position der Phenylringe. Bevorzugt sind solche Verbindungen in denen die beiden Phenylringe jeweils mit einer Hydroxy- und einer Methoxygruppe substituiert sind.

Die Substituenten $R^5$, $R^6$, $R^7$, $R^8$, $R^9$, $R^{10}$ in der Heptadiendion-Struktureinheit können jeweils unabhängig voneinander Wasserstoff oder Alkyl mit 1 bis 6 C-Atomen sein. Bevorzugte Verbindungen sind solche in denen die Reste R bis $R^{10}$ Wasserstoff und/oder Methyl bedeuten.

Erfindungsgemäß einzusetzende Verbindungen sind beispielsweise
1,7-Bis-(3-methoxy-4-hydroxy-phenyl)-1,6-heptadien-3,5-dion
1,7-Bis-(3-methoxy-4-hydroxy-phenyl)-3,3-dimethyl-1,6-heptadien-3,5-dion
1,7-Bis-(3-methoxy-4-hydroxy-phenyl)-1,2,6,7-tetramethyl-1,6-heptadien-3,5-dion
1,7-Bis-(3-methoxy-4-hydroxy-phenyl)-1,2,3,3,6,7-hexamethyl-1,6-heptadien-3,5-dion
1,7-Bis-(3-ethoxy-4-hydroxy-phenyl)-1,6-heptadien-3,5-dion

Die erfindungsgemäß einzusetzenden Verbindungen sind an sich bekannte Farbstoffe. Sie sind kommerziell verfügbar oder lassen sich in einfacher Weise nach bekannten Methoden der präparativen organischen Chemie erhalten. Besonders bevorzugt ist die Verbindung 1,7-Bis-(3-methoxy 4-hydroxy-phenyl)-1,6-heptadien-3,5-dion, die auch unter der Bezeichnung Curcumin bekannt ist.

Die Verbindungen der Formel I weisen bin ausgeprägtes Absorptionsverhalten im Wellenlängenbereich zwischen etwa 350 und 450 nm, insbesondere in dem üblicherweise in Belichtungseinrichtungen in der Fotoresist-Technik angewandten Bereich zwischen 400 und 450 nm, auf. Weiterhin sind diese Verbindungen in Positiv-Fotoresist-Zusammensetzungen auf Diazochinon/Novolakharz-Basis sehr gut löslich, wobei

sie schon bei geringen bis mäßigen Konzentrationen, etwa im Bereich von 0,1 - 10 Gew.%, bezogen auf den Feststoffgehalt der Fotoresist-Zusammensetzung, eine Absorption des eingestrahlten Lichtes von über 90 96 bewirken. Durch Zusatz der Verbindungen der Formel I zu Positiv-Fotoresist-Zusammensetzungen werden unerwünschte Streustrahlungs- und. Halationseffekte, die sich insbesondere in Resistschichten auf hochreflektiven Substraten störend bemerkbar machen, sehr wirksam unterbunden. Ein besonderer Vorteil der Verbindungen der Formel I ist, daß sie auch bei Temperaturen um 200 °C noch stabil sind und sich nicht aus der Resistschicht verflüchtigen. Die strahlungsabsorbierende Wirkung dieser Farbstoffe in der Resistschicht bleibt somit auch nach Temperatureinwirkung von 150 - 200 °C voll erhalten. Eine Verunreinigung der Prozeßgeräte durch sublimierten Farbstoff tritt nicht auf.

Die erfindungsgemäßen mindestens eine Verbindung der Formel I enthaltenden Positiv-Fotoresist-Zusammensetzungen basieren im wesentlichen auf Phenol-Formaldehyd-Kondensaten vom Novolakharz-Typ und lichtempfindlichen o-Chinondiazid-Verbindungen. Insbesondere sind dies Gemische aus Kondensationsprodukten von Formaldehyd mit Phenolen oder phenolische Hydroxylgruppen enthaltende Verbindungen und Naphthochinondiazidsulfonyl-Derivaten. Derartige Fotoresistmaterialien bzw. deren als wesentlich anzusehenden Bestandteile sind vielfältig aus dem Stand der Technik bekannt, etwa aus den Patentschriften DE-PS 938 233/US-PS 3,106,465 und DE-PS 1 195 166/US-PS 3,200,239, der deutschen Offenlegungsschrift DE-OS 32 20 816 und der deutschen Patentanmeldung P 33 44 202. Entsprechende Materialien sowie Fertigformulierungen sind von verschiedensten Anbietern im Handel.

Die Formulierung der erfindungsgemäßen Positiv-Fotoresist-Zusammensetzungen erfolgt in an sich bekannter Weise durch Mischen der Komponenten bzw. Lösen in einem geeigneten Lösungsmittel, wobei die erfindungsgemäß einzusetzenden Verbindungen der Formel I in einem Anteil von 0,1 - 10 Gew.%, vorzugsweise 1 - 5 Gew.%, bezogen auf den Feststoffgehalt der Fotoresist-Zusammensetzung, zugesetzt werden. Gleichermaßen ist es möglich, fertigformulierte Positiv-Fotoresist-Zusammensetzungen, wie sie etwa im Handel sind, mit der entsprechenden Menge an Verbindungen der Formel I zu versetzen.

Die Anwendung der erfindungsgemäßen Positiv-Fotoresist-Zusammensetzungen erfolgt in an sich bekannter Weise mit den hierfür üblichen Prozeßgeräten. Mit ihnen lassen sich auch auf hochreflektiven Substraten positive Fotoresist-Reliefstrukturen höchster Auflösung, Kantensteilheit und Wiedergabetreue erhalten.

Beispiel 1

a) In eine handelsübliche Positiv-Fotoresist-Zusammensetzung auf Diazochinon/Novolakharz-Basis (Selectilux® P 100, Fa. E. Merck, Darmstadt) werden 3 Gew.% Curcumin eingearbeitet.

Auf ein Quarzglasplättchen wird durch Schleuderbeschichten mit dieser Fotoresist-Formulierung eine 1 µm dicke Schicht aufgetragen und zur Entfernung des Lösungsmittels 1 Minute lang bei 100 °C vorgetrocknet. Anschließend wird die Resistschicht 30 Minuten lang auf 200 °C erhitzt und danach die optische Transmission bestimmt.

Sie beträgt bei 405 nm nur 6,5 %, bei 436 nm 8,1 % der eingestrahlten Lichtenergie. Mehr als 90 % des eingestrahlten Lichtes wird somit absorbiert.

b) Wird die Fotoresist-Zusammensetzung nach a) in derselben Weise auf Siliziumscheiben aufgebracht und behandelt, so lassen sich in den Prozeßapparaturen keine Spuren von sublimiertem Farbstoff feststellen.

Durch Belichten der mit der Fotoresistschicht versehenen Siliziumscheiben durch eine Auflösungstestmaske und anschließendes Entwickeln in einem handelsüblichen wäßrig-alkalischen Entwickler lassen sich kantenscharfe Reliefstrukturen mit einer Auflösung bis 1 µm erhalten.

Beispiel 2 (Vergleichsbeispiel)

Der in Beispiel 1 genannte handelsübliche Fotolack wird mit 5 Gew.% 4-N-Ethyl-N-(2-phenoxyethyl)-aminoazobenzol (Farbstoff gemäß deutscher Offenlegungsschrift DE-OS 33 24 795) versetzt.

Bei einer Anwendung und Behandlung gemäß Beispiel 1a) beträgt die optische Transmission bei 405 nm 12 % und bei 436 nm 14,7 96.

Bei einer Anwendung und Behandlung gemäß Beispiel 1b) lassen sich in den Prozeßapparaturen deutliche Verfärbungen aufgrund sublimierten Farbstoffes feststellen.

Die damit hergestellten Fotoresist-Reliefstrukturen zeigen eine deutlich schlechtere Auflösung, Kantensteilheit und Wiedergabetreue.

**Patentansprüche**

1. Positiv-Fotoresist-Zusammensetzungen auf Diazochinon/Novolakharz-Basis, dadurch gekennzeichnet, daß diese mindestens eine Verbindung der allgemeinen Formel I

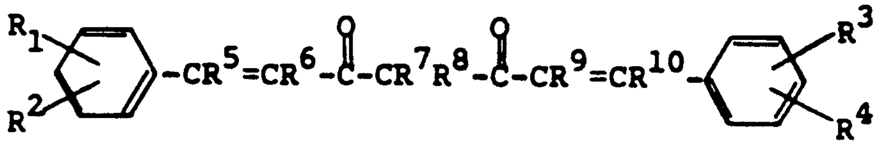

(I)

worin

$R^1$ bis $R^4$ jeweils Hydroxy oder $C_{1-6}$-Alkoxy und

$R^5$ bis $R^{10}$ jeweils Wasserstoff oder $C_{1-6}$-Alkyl bedeutet,

enthalten.

2. Positiv-Fotoresist-Zusammensetzungen nach Anspruch 1, dadurch gekennzeichnet, daß darin die Verbindungen der Formel I in einem Anteil von 0,1 - 10 Gew.%, vorzugsweise 1 - 5 Gew.%, bezogen auf den Feststoffgehalt, enthalten sind.

3. Verwendung von Verbindungen der allgemeinen Formel I zur Unterdrückung von Streustrahlungs- bzw. Halationseffekten in Positiv-Fotoresist-Beschichtungen.

## Claims

1. A positive photoresist composition based on a diazoquinone/novolak resin, which contains at least one compound of the general formula I

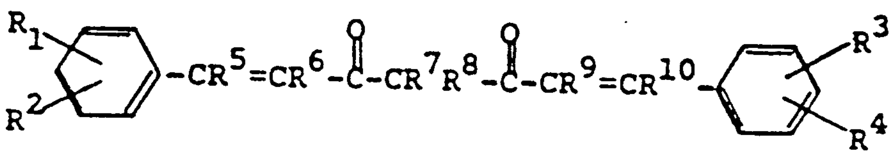

(I)

in which

$R^1$ to $R^4$ are each hydroxyl or $C_1$-$C_6$alkoxy and $R^5$ to $R^{10}$ are each hydrogen or $C_{1-6}$alkyl.

2. A positive photoresist composition according to claim 1, wherein the compounds of the formula I are present therein in an amount of 0.1 - 10 % by weight, preferably 1 - 5 % by weight, based on the solids content.

3. Use of a compound of the general formula I for suppressing stray radiation or halation effects in positive photoresist coatings.

## Revendications

1. Compositions pour photoréserves positives à base d'une diazoquinone et d'une résine novolaque, compositions caractérisées en ce qu'elles contiennent au moins un composé répondant à la formule générale I :

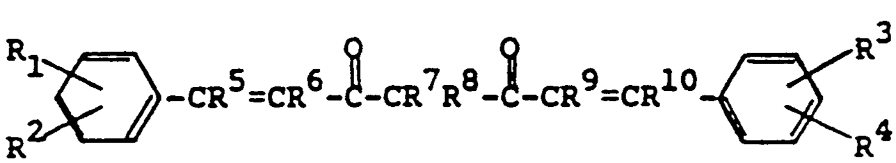

(I)

dans laquelle

$R_1$ à $R_4$ représentent chacun un hydroxy ou un alcoxy en $C_1$-$C_6$, et

$R^5$ à $R^{10}$ représentent chacun l'hydrogène ou un alkyle en $C_1$-$C_6$.

**2.** Compositions pour photoréserves positives selon la revendication 1, caractérisées en ce que les composés de formule I y sont contenus en une proportion de 0,1 à 10% en poids, de préférence de 1 à 5% en poids, par rapport à la quantité de matières solides qui s'y trouve.

**3.** Application de composés de formule générale I pour diminuer les effets de rayonnement diffusé ou de formation de halos dans des revêtements de photoréserves positives.